# EUROPÄISCHE PATENTSCHRIFT

(11) **EP 3 472 629 B1**
(45) Veröffentlichungstag und Bekanntmachung des Hinweises auf die Patenterteilung: **25.09.2019**
(21) Anmeldenummer: 17752048.3
(22) Anmeldetag: 01.08.2017
(51) Int. Cl.: G01R 1/20

(54) **MESSANORDNUNG ZUR MESSUNG EINES ELEKTRISCHEN STROMS IM HOCHSTROMBEREICH**
MEASURING ARRANGEMENT FOR MEASURING AN ELECTRIC CURRENT IN THE HIGH-CURRENT RANGE
SYSTÈME DE MESURE SERVANT À MESURER UN COURANT ÉLECTRIQUE DANS LA PLAGE DES COURANTS FORTS

(30) Priorität: 17.08.2016 DE 102016010012
(43) Veröffentlichungstag der Anmeldung: 24.04.2019
(73) Patentinhaber: Isabellenhütte Heusler GmbH & Co.KG, 35683 Dillenburg (DE)
(72) Erfinder: HETZLER, Ullrich, 35688 Dillenburg-Oberscheld (DE); POLLMANN, Michael, 35689 Dillenburg (DE)
(74) Vertreter: v. Bezold & Partner Patentanwälte - PartG mbB
(86) Internationale Anmeldenummer: PCT/EP2017/069443
(87) Internationale Veröffentlichungsnummer: WO 2018/033380

(56) Entgegenhaltungen:
- DE-A1- 2 939 594
- DE-A1-102013 005 939
- DE-A1-102014 207 756
- DE-A1-102014 218 708
- DE-C- 614 602
- DE-U1-202009 010 319
- FR-A- 1 454 129

## Beschreibung

Die Erfindung betrifft eine Messanordnung zur Messung eines elektrischen Stroms im Hochstrombereich, insbesondere im Strombereich von mehr als 1 kA.

Es ist beispielsweise aus EP 0 605 800 A1 bekannt, elektrische Ströme mittels eines niederohmigen Strommesswiderstands ("Shunt") gemäß der Vierleitertechnik zu messen. Hierbei fließt der zu messende elektrische Strom durch den niederohmigen Strommesswiderstand, wobei der Spannungsabfall über den Strommesswiderstand gemessen wird und dann entsprechend dem ohmschen Gesetz ein Maß für den elektrischen Strom bildet.

Aus WO 2014/127788 A1 ist es weiterhin bekannt, die Vierleitertechnik auch zur Strommessung in Mittelspannungsanlagen und Hochspannungsanlagen einzusetzen. Allerdings wird in dieser Druckschrift noch keine befriedigende Lösung angeboten zur Auslegung des Widerstandes und zur elektrischen Anbindung des Strommesswiderstands an die Mittelspannungsanlage bzw. die Hochspannungsanlage.

Weiterhin ist aus US 2007/0177318 A1 ein Strommesswiderstand bekannt, der eine Strommessung gemäß der Vierleitertechnik ermöglicht. Allerdings ist dieser bekannte Strommesswiderstand zur Montage auf einer Leiterplatte konzipiert und somit nicht zur Strommessung in einer Mittelspannungsanlage bzw. Hochspannungsanlage geeignet. Dieser bekannte Strommesswiderstand weist jedoch bereits eine Messschaltung auf, um den Spannungsabfall über dem Widerstandselement des Strommesswiderstands zu messen, wobei die Messschaltung oben auf den Strommesswiderstand aufgesteckt werden kann und dann durch eine Rastverbindung mit dem Strommesswiderstand verbunden ist. Die fehlende Eignung zur Hochstrommessung in einer Mittelspannungsanlage bzw. Hochspannungsanlage rührt hierbei auch daher, dass die Messschaltung nicht baulich integriert ist und deshalb nicht abgeschirmt ist. Bei einer Hochstrommessung in einer Mittelspannungsanlage bzw. Hochspannungsanlage können die elektronischen Komponenten der Messschaltung deshalb gestört werden.

Ferner ist zum allgemeinen technischen Hintergrund der Erfindung auch hinzuweisen auf US 6 801 118 B1, WO 2013/037677 A1 und US 3 245 021 A.

Aus DE 29 39 594 A1, FR 1 454 129 A und DE 10 2013 005939 A1 ist teilweise eine Messanordnung gemäß dem Oberbegriff von Anspruch 1 bekannt. Diese bekannte Messanordnung ist jedoch noch nicht vollständig befriedigend.

Der Erfindung liegt deshalb die Aufgabe zugrunde, eine entsprechend verbesserte Messanordnung zu schaffen.

Diese Aufgabe wird durch eine erfindungsgemäße Messanordnung gemäß dem Hauptanspruch gelöst.

Die erfindungsgemäße Messanordnung weist zunächst in Übereinstimmung mit dem Stand der Technik einen niederohmigen Strommesswiderstand auf, um einen elektrischen Strom gemäß der bekannten Vierleitertechnik zu messen. Der Strommesswiderstand besteht im Wesentlichen aus einem ersten Anschlussteil aus einem Leitermaterial (z.B. Kupfer) zum Einleiten des zu messenden elektrischen Stroms in den Strommesswiderstand, einem zweiten Anschlussteil aus einem Leitermaterial (z.B. Kupfer) zum Ausleiten des zu messenden elektrischen Strom aus dem Strommesswiderstand und einem Widerstandselement aus einem Widerstandsmaterial (z.B. Manganin®), wobei das Widerstandselement elektrisch zwischen die beiden Anschlussteile geschaltet ist und von dem zu messenden elektrischen Strom durchflossen wird. Derartige niederohmige Strommesswiderstände sind grundsätzlich aus EP 0 605 800 A1 bekannt, müssen aber hinsichtlich Widerstandswert, Abmessungen und Form an die Größe des zu messenden elektrischen Stroms und an die Anforderungen des Kunden angepasst werden.

Weiterhin umfasst die erfindungsgemäße Messanordnung eine baulich integrierte Messschaltung, welche die über dem Widerstandselement abfallende elektrische Spannung misst. Beispielsweise kann diese Messschaltung als anwendungsspezifische integrierte Schaltung (ASIC: Application-specific integrated circuit) ausgebildet sein. Derartige ASICs sind beispielsweise aus EP 1 363 131 A1 bekannt. Es ist jedoch zu erwähnen, dass die integrierte Messschaltung vorzugsweise eine 16-Bit-Messwerterfassung aufweist.

Die erfindungsgemäße Messanordnung zeichnet sich nun zunächst dadurch aus, dass die Messung der über dem Widerstandselement des Strommesswiderstands abfallenden elektrischen Spannung nicht durch ein einziges Paar von Spannungsabgriffen erfolgt, sondern durch mehrere Paare von Spannungsabgriffen, wobei die Paare von Spannungsabgriffen mit der Messschaltung verbunden sind. Dies ist vorteilhaft, weil die Stromdichte in dem Widerstandselement des niederohmigen Strommesswiderstands räumlich nicht konstant ist. Dies hat zur Folge, dass der Messwert der über dem Widerstandselement abfallenden Spannung von der räumlichen Positionierung der Spannungsabgriffe abhängt, was zu einem Messfehler führt. Bei der erfindungsgemäßen Messanordnung mit mehreren räumlich verteilt angeordneten Paaren von Spannungsabgriffen besteht dagegen die Möglichkeit, dass die Messschaltung mehrere Spannungsmesswerte auswertet, die an den verschiedenen Paaren von Spannungsabgriffen gemessen werden. Aus diesen verschiedenen Spannungsmesswerten kann dann beispielsweise ein Mittelwert berechnet werden, wodurch der Messfehler minimiert wird. Einzelheiten hierzu sind aus WO 2014/161624 A1 bekannt.

Darüber hinaus zeichnet sich die erfindungsgemäße Messanordnung durch zwei Stromschienenanschlüsse aus, um die Messanordnung mit Stromschienen verbinden zu können. Der erste Stromschienenanschluss (vorzugsweise für die Kontaktierung mit jeweils drei übereinander angeordneten Stromschienen) ist hierbei mit dem ersten Anschlussteil des niederohmigen Strommesswiderstands elektrisch verbunden, während der zweite Stromschienenanschluss mit dem zweiten Anschlussteil des niederohmigen Strommesswiderstands elektrisch verbunden ist. Die erfindungsgemäße Messanordnung ermöglicht deshalb vorteilhaft eine einfache und zuverlässige elektrische Verbindung mit Stromschienen in einer Hochstromanordnung.

In einem bevorzugten Ausführungsbeispiel der Erfindung weisen die beiden Stromschienenanschlüsse jeweils mehrere parallel übereinanderliegende Anschlussplatten aus einem Leitermaterial auf. Dies ermöglicht die Kontaktierung mit jeweils drei übereinander angeordneten Stromschienen und bietet den Vorteil, dass der zu messende elektrische Strom aufgeteilt wird und durch die verschiedenen Anschlussplatten fließt, wodurch die Stromdichte auch bei einer Hochstrommessung in einem relativ niedrigen Bereich bleibt und die Stromtragfähigkeit der Stromschienenanschlüsse nicht überschreitet.

Weiterhin ist zu erwähnen, dass die beiden Stromschienenanschlüsse vorzugsweise zur Schraubmontage an den Stromschienen ausgelegt sind. Hierzu können die Stromschienenanschlüsse beispielsweise Bohrungen zur Durchführung einer Schraubverbindung aufweisen.

Ferner ist zu erwähnen, dass die Stromschienenanschlüsse vorzugsweise vernickelt, verzinnt, versilbert oder vergoldet sind, um die Beständigkeit gegenüber Umwelteinflüssen zu verbessern.

In dem bevorzugten Ausführungsbeispiel der Erfindung weist die Messanordnung mehrere niederohmige Strommesswiderstände auf, die elektrisch parallel geschaltet sind, so dass sich der zu messende Strom in mehrere Teilströme aufteilt, die durch die einzelnen Strommesswiderstände fließen. Die Strommesswiderstände können hierbei in mehreren Ebenen übereinander angeordnet sein. Darüber hinaus können in jeder der Ebene jeweils mehrere Strommesswiderstände nebeneinander angeordnet sein. Bei einer Fertigung des niederohmigen Strommesswiderstands aus einem Verbundmaterialband gemäß EP 0 605 800 A1 kann diese Unterteilung in mehrere Strommesswiderstände dadurch erreicht werden, dass in den Streifen aus dem Widerstandsmaterial mehrere Schlitze eingebracht werden, die längs zur Stromflussrichtung verlaufen und quer zur Stromflussrichtung nebeneinander angeordnet sind. Die Schlitze trennen dann in dem Verbundmaterialband und dem daraus resultierenden Strommesswiderstand mehrere nebeneinanderliegende Widerstandselemente voneinander.

Eine Besonderheit stellt die Integration der kompletten Mess- und Auswerteelektronik im Shunt in unmittelbarer Nähe zu den Spannungsabgriffen dar. Die Verbindung zwischen Spannungsabgriff und Messwandler (z. B. ASICs) erfolgt vorzugsweise mit Flexleitungen in Stripline-Technik. Beide Maßnahmen (kurze Leitungen und Stripline-Technik) führen zu einer sehr störsicheren Messanordnung (extrem kleine Antennenfläche).

Weiterhin ist zu erwähnen, dass mit dem Einbau im Shunt die elektronischen Komponenten (z. B. Messschaltung, Datenschnittstelle) der erfindungsgemäßen Messanordnung innerhalb einer elektrischen Abschirmung aus einem Leitermaterial eingekapselt sind. Dies ist sinnvoll, da bei einer Hochstrommessung ansonsten eine Störung der elektronischen Komponenten durch den zu messenden elektrischen Strom möglich wäre. Die elektrische Abschirmung wird durch die Stromschienenanschlüsse, Distanzstücke zwischen den Stromschienenanschlüssen und seitliche, einseitig elektrisch isolierte Verstärkungsplatten aus einem Leitermaterial gebildet. Auf Ober-und Unterseite sind zusätzliche Abschirmbleche aus ferromagnetischen Materialien elektrisch einseitig isoliert angebracht.

Vorzugsweise umfasst die Messanordnung auch eine baulich integrierte Datenschnittstelle zum Senden von Daten an eine kundenseitige Auswertungseinheit und/oder zum Empfangen von Daten von außen. Die Datenschnittstelle bildet vorzugsweise auch eine galvanische Trennung, da die Messanordnung einerseits und die Auswertungseinheit andererseits üblicherweise auf unterschiedlichen elektrischen Potentialen liegen. Diese galvanische Trennung kann beispielsweise durch einen Optokoppler zusammen mit einen Lichtleiterrealisiert werden. Einzelheiten zur technischen Realisierung einer solchen Datenschnittstelle sind beispielsweise aus WO 2014/127788 A1 bekannt.

Ferner ist zu erwähnen, dass das Widerstandsmaterial des Widerstandselements in dem niederohmigen Strommesswiderstand zwar eine extrem geringe Temperaturabhängigkeit seines Widerstandswerts aufweist, die jedoch trotzdem nicht vernachlässigt werden kann, wenn man eine sehr genaue Messung anstrebt. Zur Kompensation dieser Temperaturabhängigkeit kann die Messanordnung einen oder mehrere Temperatursensoren aufweisen, die die Temperatur des Widerstandselements des niederohmigen Strommesswiderstands messen und den Messwert der über dem Widerstandselement abfallenden elektrischen Spannung entsprechend einer temperaturabhängigen Korrekturkennlinie korrigiert.

Weiterhin ist zu erwähnen, dass das Widerstandsmaterial des Widerstandselements des niederohmigen Strommesswiderstands eine bestimmte Thermokraft aufweist, die bei einem Temperaturunterschied zwischen dem Widerstandselement einerseits und den Anschlussteilen andererseits eine bestimmte Thermospannung erzeugt. Diese Thermospannung überlagert sich zu der Spannung, die durch den zu messenden elektrischen Strom in dem Widerstandselement erzeugt wird und führt deshalb zu einem Messfehler. In dem bevorzugten Ausführungsbeispiel der Erfindung ist deshalb zur Kompensation der über dem Widerstandselement abfallenden Thermospannung ein Ausgleichselement vorgesehen, das thermisch mit den beiden Anschlussteilen verbunden ist und so denselben Temperaturunterschieden ausgesetzt ist wie das Widerstandselement. Bei einem Temperaturunterschied zwischen dem Ausgleichselement einerseits und den Anschlussteilen andererseits erzeugt das Ausgleichselement also eine bestimmte Thermospannung. Das Ausgleichselement und das Widerstandselement sind hierbei in einem Spannungsmesskreis elektrisch in Reihe geschaltet, so dass sich die Thermospannung der Widerstandselements einerseits und des Ausgleichselements andererseits mindestens teilweise kompensieren. Die Einzelheiten dieser Thermospannungskompensation sind in der deutschen Patentanmeldung 10 2016 008 415.4 beschrieben. Zusätzlich zu diesem Kompensationselement wird vorzugsweise an jeder Spannungsmess-Stelle die Temperaturdifferenz gemessen, so dass bei unvollständiger Kompensation der Thermospannung zusätzlich eine rechnerische Korrektur erfolgen kann.

Es wurde bereits vorstehend erwähnt, dass die Messanordnung Spannungsabgriffe aufweist zum Abgreifen der über dem Strommesswiderstand abfallenden elektrischen Spannung. Diese Spannungsabgriffe können vorteilhaft in ein Flachbandkabel integriert werden, das auf dem Strommesswiderstand elektrisch flächig kontaktiert ist. Dieses Flachbandkabel ist vorzugsweise mehrlagig und bildet einen Streifenleiter, wobei auch der bereits vorstehend erwähnte Temperatursensor und der Temperaturdifferenzsensor auf dem Flachbandkabel angebracht sein kann. Darüber hinaus kann auch das bereits vorstehend erwähnte und zum Ausgleich der Thermospannung dienende Ausgleichselement auf dem Flachbandkabel angebracht sein.

Das direkte Anlöten des Flachbandkabels auf dem niederohmigen Strommesswiderstand ist wegen der extrem guten Wärmeableitung des Kupfers und der limitierten Temperaturbelastbarkeit des Flachbandkabels in der Regel nicht möglich. Zwischen dem Flachbandkabel und dem Strommesswiderstand ist deshalb vorzugsweise ein Plättchen aus einem Leitermaterial (z. B. Kupfer) angeordnet, wobei dieses Plättchen durch Löten, Sintern, Schweißen oder auch Leitkleben (d.h. Herstellen einer elektrisch leitfähigen Klebeverbindung) mit dem Strommesswiderstand verbunden wird. Dieses Plättchen weist zur elektrischen Kontaktierung des Flachbandkabels Anschlussstifte (Pins) auf, die hochgebogen werden können, woraufhin die Anschlussstifte des Plättchens dann mit entsprechenden elektrischen Anschlussstellen des Flachbandkabels verbunden (verlötet, verschweißt oder mit Leitkleber verklebt) werden können.

Das Plättchen zwischen dem Flachbandkabel und dem Strommesswiderstand erleichtert also die Verbindung zwischen dem Flachbandkabel und dem Strommesswiderstand.

In einer Variante der Erfindung weist die Messanordnung zur Stromversorgung der elektronischen Komponenten einen Hochspannungstransformator auf.

In einer anderen Variante der Erfindung ist dagegen zur Stromversorgung eine Photovoltaikzelle vorgesehen, die zur Stromerzeugung über einen Lichtleiter von einer Lichtquelle (z. B. Laser oder LED) bestrahlt wird. Einzelheiten über diese Art der Stromerzeugung sind beispielsweise aus WO 2014/127788 A1 bekannt.

Gemäß der Erfindung weist der Strommesswiderstand mehrere ebene Verbundmaterialplatten auf, wie sie beispielsweise aus EP 0 605 800 A1 bekannt sind, wobei diese Verbundmaterialplatten das Widerstandselement und die Anschlussteile umfassen. Die Verbundmaterialplatten sind hierbei parallel zueinander übereinander angeordnet. Die benachbarten Verbundmaterialplatten sind hierbei an den Anschlussteilen elektrisch und mechanisch miteinander verbunden, während die benachbarten Verbundmaterialplatten im Bereich der Widerstandselemente durch einen Isolierspalt elektrisch voneinander getrennt sind. Der zu messende elektrische Strom teilt sich also auf und fließt getrennt durch die benachbarten Widerstandselemente der übereinanderliegenden Verbundmaterialplatten.

Die Stromaufteilung kann jedoch nicht nur in vertikaler Richtung erfolgen, sondern auch in horizontaler Richtung, d. h. innerhalb einer Verbundmaterialplatte. Hierzu weisen die Verbundmaterialplatten jeweils mehrere Schlitze auf, die längs zur Stromflussrichtung verlaufen und quer zur Stromflussrichtung nebeneinander angeordnet sind, wobei die Schlitze in den einzelnen Verbundmaterialplatten jeweils mehrere Widerstandselemente voneinander trennen.

Der Strommesswiderstand kann beispielsweise einen Widerstandswert im Bereich von 1 µΩ - 1 mΩ haben.

Bei dem Widerstandmaterial des Strommesswiderstands kann es sich beispielsweise um eine Kupfer-Mangan-Nickel-Legierung handeln, wie beispielsweise Cu86Mn12Ni2. Alternativ besteht auch die Möglichkeit, dass es sich bei dem Widerstandsmaterial um eine Kupfer-Mangan-Zinn-Legierung handelt, wie beispielsweise Cu90,7Mn7Sn2,3. Ferner kann auch eine Nickel-Chrom-Legierung eingesetzt werden, insbesondere eine Nickel-Chrom-Aluminium-Legierung, wie beispielsweise Ni74,5Cr20Al13,5Si1Mn0,5Fe0,5.

Bei dem Leitermaterial handelt es sich vorzugsweise um Kupfer oder eine Kupferlegierung. Hierbei ist zu erwähnen, dass das Leitermaterial vorzugsweise einen kleineren spezifischen elektrischen Widerstand aufweist als das Widerstandsmaterial des Widerstandselements.

Ferner ist zu erwähnen, dass die Messanordnung vorzugsweise mit einem hohen Strom belastbar ist. Beispielsweise kann der kurzzeitige Maximalstrom mindestens 10 kA, 25 kA, 50 kA, 100 kA, 200 kA oder sogar 500 kA betragen. Die Dauerstrombelastbarkeit beträgt dagegen vorzugsweise mindestens 1 kA, 2 kA, 5 kA, 10 kA, 20 kA oder sogar mindestens 30 kA.

Darüber hinaus ist zu erwähnen, dass das Widerstandselement in Stromflussrichtung vorzugsweise eine relativ geringe Länge aufweist, die vorzugsweise kleiner als 50 mm, 25 mm, 10 mm, 7 mm oder sogar 5 mm.

Weiterhin ist zu erwähnen, dass die Messanordnung vorzugsweise einen sehr geringen Linearitätsfehler aufweist, der vorzugsweise geringer ist als 0,1%, 0,05%, 0,01% oder sogar 0,005%.

Dabei ist die Messschaltung vorzugsweise offset-frei und weist eine Abtastrate von vorzugsweise mehr als 500 Hz, 1 kHz, 2 kHz oder 4 kHz auf.

Eine besonders vorteilhafte und für die Applikation wesentliche Eigenschaft der Messanordnung ist die Möglichkeit, sehr kleine DC-Ströme (DC: Direct current) von einigen 100 mA bis wenigen Ampere in einem hohen AC-Strom (AC: Alternating current) von z.B. 20 kA zu messen. Ermöglicht wird das durch die hohe Auflösung der Messwandler, deren Offsetfreiheit, die hohen Linearität und das extrem geringe Rauschen. Zusätzlich ist die absolut synchrone Abtastung der einzelnen Messkanäle (im beschriebenen System 8 Kanäle) von ausschlaggebender Bedeutung. Diese synchrone Messung reduziert das Rauschen des Mittelwerts nochmals um ca. 70%.

Hinsichtlich der Form des Strommesswiderstands ist zu erwähnen, dass das Widerstandselement und/oder die Anschlussteile vorzugsweise plattenförmig sind, wie es beispielsweise aus EP 0 605 800 A1 bekannt ist, wobei das Widerstandselement und die Anschlussteile wahlweise eben oder gebogen sein können.

Darüber hinaus weist der Strommesswiderstand vorzugsweise einen geringen thermischen Innenwiderstand auf, der vorzugsweise kleiner ist als 1 K/W, 0,5 K/W, 0,1 K/W, 0,05 K/W oder 0,02 K/W.

Ferner ist noch zu erwähnen, dass die Messschaltung vorzugsweise mehrere Messkanäle aufweist, nämlich einen ersten Messkanal zur Dauerstromerfassung und einen separaten zweiten Messkanal mit einer höheren Abtastrate zur Überstromerfassung.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine Perspektivansicht eines Teilbereichs der Messanordnung mit einem Kupferplättchen und einer Flexleitung,
- Figur 1B: eine vergrößerte Ansicht von Figur 1A,
- Figur 2: ein Blockschaltbild zur Verdeutlichung des Aufbaus und der Funktionsweise der erfindungsgemäßen Messanordnung,
- Figur 3A: eine Querschnittsansicht durch eine erfindungsgemäße Messanordnung, sowie
- Figur 3B: einen Strommesswiderstand aus der Messanordnung gemäß Figur 3A im Querschnitt.

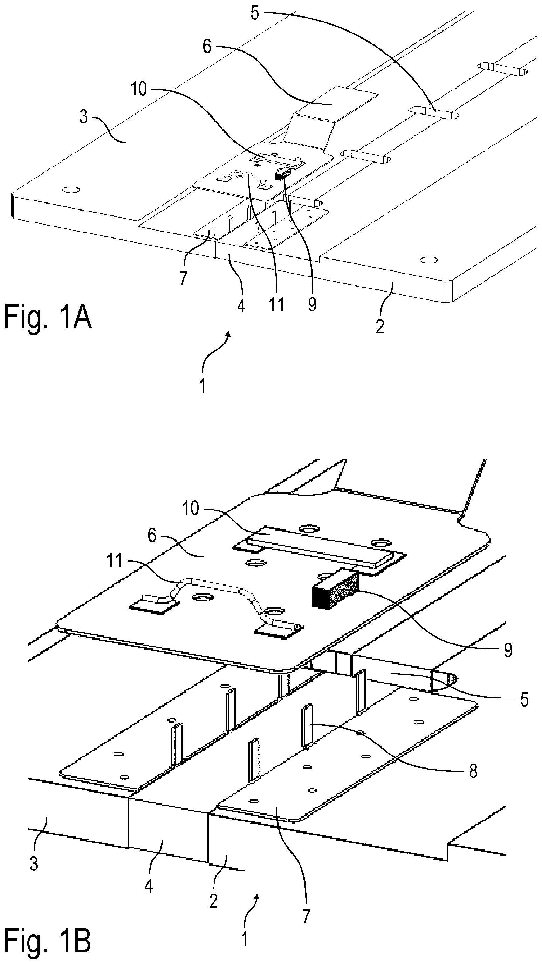

Die Figuren 1A und 1B zeigen verschiedene Ansichten eines Teilbereiches der Messanordnung mit einem von vier niederohmigen Strommesswiderständen 1 zur Strommessung gemäß der bekannten Vierleitertechnik, wobei der Strommesswiderstand 1 angepasst ist für eine Strommessung im Hochstrombereich von beispielsweise mehr als 1 kA.

Der Strommesswiderstand 1 weist zunächst ein erstes Anschlussteil 2 auf, um den zu messenden elektrischen Strom in den Strommesswiderstand 1 einzuleiten.

Darüber hinaus weist der Strommesswidertand 1 ein zweites Anschlussteil 3 auf, um den zu messenden elektrischen Strom wieder aus dem Strommesswiderstand 1 auszuleiten.

Zwischen den beiden Anschlussteilen 2, 3 ist ein Widerstandselement 4 aus einem Widerstandsmaterial angeordnet, wie beispielsweise Manganin®, Zeranin® oder Isaohm®. Das Widerstandselement 4 ist hierbei entlang seiner Längskanten durch eine Schweißverbindung mit den angrenzenden Anschlussteilen 2, 3 elektrisch und mechanisch verbunden.

In dem Strommesswiderstand 1 befinden sich mehrere Schlitze 5, die längs zur Stromflussrichtung verlaufen und nebeneinander angeordnet sind, so dass die Schlitze 5 mehrere Widerstandselemente 4 in dem Strommesswiderstand 1 elektrisch voneinander trennen. Der zu messende elektrische Strom teilt sich also in dem Strommesswiderstand 1 auf und fließt dann parallel durch die nebeneinanderliegenden Widerstandselemente 4, die durch die Schlitze 5 voneinander getrennt sind.

Auf der Oberseite des Strommesswiderstands 1 sind Flachbandkabel 6 angeordnet (beispielhaft ist nur eine Messstelle gezeigt), die auch zur Messung der über dem Widerstandselement 4 abfallenden elektrischen Spannung dienen. Ein direktes Verlöten der Flachbandkabel 6 auf dem Strommesswiderstand 1 ist jedoch nicht möglich, da der Strommesswiderstand 1 in der Messanordnung mit den Stromschienenanschlüssen verbunden ist und damit eine sehr große Wärmeleitfähigkeit hat und weil die Temperaturbelastbarkeit des Flachbandkabels 6 begrenzt ist. Zwischen den Flachbandkabeln 6 und dem Strommesswiderstand 1 ist deshalb je ein Kupferplättchen 7 angeordnet, das zunächst mit dem Strommesswiderstand 1 kontaktiert (z.B. verlötet) wird und Spannungsabgriffe bildet, um die über dem Widerstandselement 4 abfallende elektrische Spannung zu messen. An das Kupferplättchen 7 sind Anschlussstifte 8 angeformt, die nach oben gebogen werden, wie in den Zeichnungen dargestellt ist. Anschließend kann das Flachbandkabel 6 dann einfach mit den Anschlussstiften 8 verlötet werden.

Auf dem Flachbandkabel 6 befindet sich ein Temperatursensor 9, der die Aufgabe hat, die Temperatur des Widerstandselements 4 zu messen, um Messfehler kompensieren zu können, die durch die Temperaturabhängigkeit des Widerstandsmaterials des Widerstandselements 4 verursacht werden.

Darüber hinaus ist auf dem Flachbandkabel 6 auch ein Ausgleichselement 10 in Form eines Verbundmaterialplättchens angeordnet, um Thermospannungen zu kompensieren. Die Einzelheiten dieser Thermospannungskompensation sind in der deutschen Patentanmeldung 10 2016 008 415.4 beschrieben.

Ferner und optional kann auf dem Flachbandkabel 6 auch ein Thermoelement 11 zur Messung der Temperaturdifferenz angeordnet sein, um Thermospannungen rechnerisch zu kompensieren.

Zu dem Strommesswiderstand 1 ist noch zu erwähnen, dass der Strommesswiderstand 1 im montierten Zustand an Stromschienenanschlüsse angeschlossen ist, wie sie nachfolgend noch detailliert beschrieben werden.

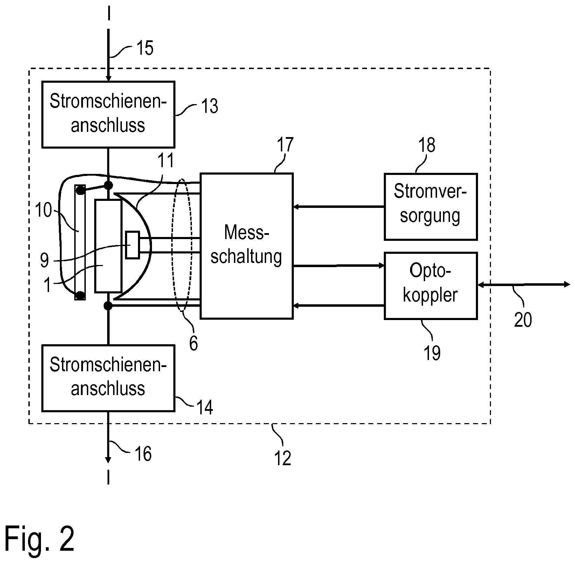

Figur 2 zeigt ein Schaltbild einer erfindungsgemäßen Messanordnung 12 mit dem Strommesswiderstand 1. In dieser Darstellung sind auch Stromschienenanschlüsse 13, 14 schematisch dargestellt, die dazu dienen, die Messanordnung 12 an Stromschienen 15, 16 anzuschließen, wobei die Stromschienen 15, 16 nur schematisch dargestellt sind.

Das Schaltbild zeigt auch eine Messschaltung 17, welche die über dem Strommesswiderstand 1 abfallende elektrische Spannung misst, um daraus gemäß dem ohmschen Gesetz den elektrischen Strom zu berechnen.

Darüber hinaus ist die Messschaltung 17 mit dem Temperatursensor 9, dem Ausgleichselement 10 und dem Thermoelement 11 verbunden. Die Verbindung mit dem Temperatursensor 9 ermöglicht eine Kompensation der Temperaturabhängigkeit des spezifischen elektrischen Widerstands des Widerstandsmaterials des Widerstandselements 4. Die Verbindung mit dem Ausgleichselement 10 ermöglicht dagegen eine Kompensation von Thermospannungen. Hierzu ist das Ausgleichselement 10 mit dem Strommesswiderstand 1 im Spannungsmesskreis in Reihe geschaltet, so dass sich die Thermospannungen über dem Strommesswiderstand 1 einerseits und über dem Ausgleichselement 10 andererseits mindestens teilweise ausgleichen. Das Thermoelement 11 ist optional und ermöglicht über die Messung der Temperaturdifferenz eine rechnerische Korrektur der Thermospannung.

Darüber hinaus zeigt die Darstellung eine Stromversorgung 18, die beispielsweise als Hochspannungstransformator oder mittels einer Fotozelle realisiert werden kann, wie beispielsweise in WO 2014/127788 A1 beschrieben ist.

Ferner weist die Messanordnung 12 eine Datenschnittstelle 19 mit einem Optokoppler auf, um Daten über einen Lichtleiter 20 an eine externe Auswertungseinheit übertragen zu können, wobei Optokoppler und Lichtleiter eine effektive galvanische Trennung bilden.

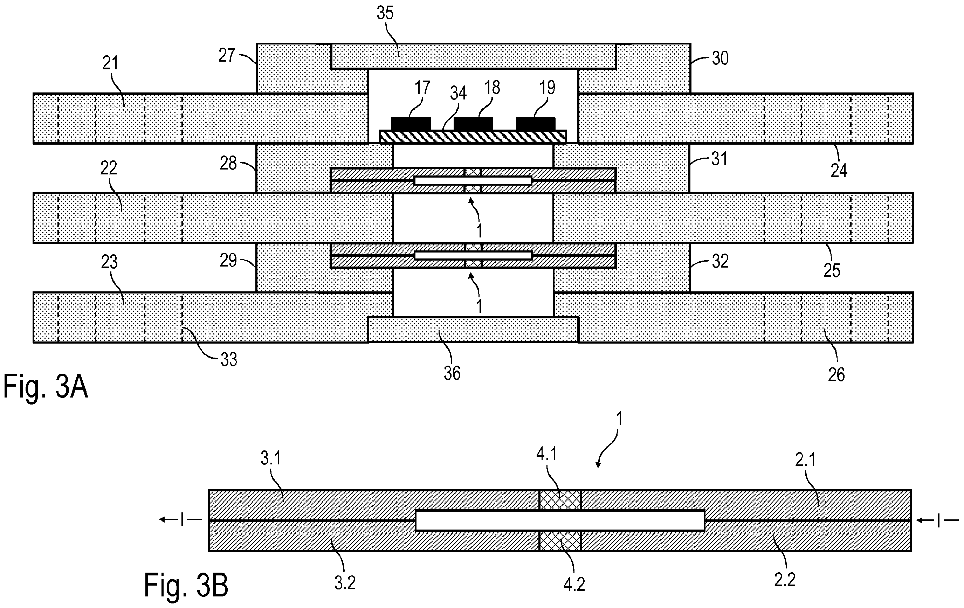

Die Figuren 3A und 3B zeigen eine Querschnittansicht durch eine erfindungsgemäße Messanordnung 12, die teilweise mit dem vorstehend beschriebenen Ausführungsbeispiel übereinstimmt, so dass zur Vermeidung von Wiederholungen auf die vorstehende Beschreibung verwiesen wird, wobei für entsprechende Einzelheit dieselben Bezugszeichen verwendet werden.

Hierbei ist zu erwähnen, dass diese Messanordnung 12 mehrere Anschlussplatten 21-26 aus einem Leitermaterial (z.B. Kupfer) aufweist, wobei die Anschlussplatten 21-26 in drei Ebenen parallel zueinander übereinander angeordnet sind. Zwischen den Anschlussplatten 21-26 bzw. an der Oberseite der Anschlussplatten 21, 24 befinden sich mehrere Distanzstücke 27-32, die ebenfalls aus einem Leitermaterial (z.B. Kupfer) bestehen.

Die Anschlussplatten 21-26 sind Bestandteil der Stromschienenanschlüsse 13, 14 und für eine Schraubmontage ausgelegt. Hierzu weisen die Anschlussplatten 21-26 jeweils Durchgangsbohrungen 33 auf.

Die Messanordnung 12 weist zwei Strommesswiderstände 1 (jeweils bestehend aus zwei Einzelwiderständen) auf, die in Figur 3B im Detail dargestellt sind.

So weist der Strommesswiderstand 1 zwei Anschlussteile 2.1, 2.2 zum Einleiten des elektrischen Stroms und zwei Anschlussteile 3.1, 3.2 zum Ausleiten des elektrischen Stroms auf, die jeweils miteinander verbunden sind. Dazwischen sind zwei Widerstandselemente 4.1, 4.2 aus einem Widerstandsmaterial angeordnet. Der zu messende elektrische Strom teilt sich also in dem Strommesswiderstand 1 auf und fließt getrennt durch die beiden Widerstandselemente 4.1, 4.2.

In der Messanordnung 12 befindet sich auch eine Leiterplatte 34 mit der Messschaltung 17, der Stromversorgung 18 und der Datenschnittstelle 19.

Die Leiterplatte 34 ist über das Flachbandkabel 6 mit den beiden Strommesswiderständen 1 verbunden, wobei das Flachbandkabel 6 in den Figuren 3A und 3B nicht dargestellt ist.

An der Oberseite ist die Messanordnung 12 durch einen Deckel 35 verschlossen, während an der Unterseite ein Boden 36 die Messanordnung 12 verschließt. Der Deckel 35 und der Boden 36 bestehen aus einem elektrisch isolierenden Material oder weisen zumindest eine elektrisch isolierende Ummantelung auf, um einen unerwünschten Kurzschluss über den Deckel 35 oder den Boden 36 zu verhindern. Der Deckel 35 und der Boden 26 beinhalten ein elektrisch leitfähiges, bevorzugt ferromagnetisches Abschirmmaterial, das zumindest einseitig vom der Messanordnung isoliert ist.

Auf Vorder- und Rückseite in Fig. 3 (d.h. vor und hinter der Zeichenebene) ist eine mechanische Verstärkungsplatte aufgebracht, die einseitig von der Messanordnung isoliert und mit den aus Kupfer bestehenden Anschlussplatten 21-26 verschraubt sind. Diese Verstärkungsplatten sind in Fig. 3 nicht dargestellt.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen. Der Schutzbereich ist durch die Ansprüchen definiert.

### Bezugszeichenliste:

- 1: Strommesswiderstand als Teil der Messanordnung
- 2, 2.1, 2.2: Anschlussteil zum Einleiten des Stroms
- 3, 3.1, 3.2: Anschlussteil zum Ausleiten des Stroms
- 4, 4.1, 4.2: Widerstandselement
- 5: Schlitze zur Trennung der Widerstandselemente
- 6: Flachbandkabel
- 7: Kupferplättchen
- 8: Anschlussstifte des Kupferplättchens
- 9: Temperatursensor
- 10: Ausgleichselement als Verbundmaterialplättchen
- 11: Thermoelement
- 12: Messanordnung zur Strommessung
- 13: Stromschienenanschluss
- 14: Stromschienenanschluss
- 15, 16: externe Stromschienen
- 17: Messschaltung
- 18: Stromversorgung
- 19: Datenschnittstelle mit Optokoppler
- 20: Lichtleiter
- 21-26: Anschlussplatten aus Kupfer
- 27-32: Distanzstücke aus Kupfer
- 33: Bohrungen in den Anschlussplatten für Schraubmontage
- 34: Leiterplatte
- 35: Deckel zur elektrischen Abschirmung
- 36: Boden zur elektrischen Abschirmung
- I: Strom

## Patentansprüche

1. Messanordnung (12) zur Messung eines elektrischen Stroms (I) im Hochstrombereich, insbesondere im Strombereich von mehr als 1kA, mit
a) einem niederohmigen Strommesswiderstand (1) zur Strommessung gemäß der Vierleitertechnik, mit
a1) einem ersten Anschlussteil (2) aus einem Leitermaterial zum Einleiten des zu messenden elektrischen Stroms (I) in den Strommesswiderstand (1),
a2) einem zweiten Anschlussteil (3) aus einem Leitermaterial zum Ausleiten des zu messenden elektrischen Stroms (I) aus dem Strommesswiderstand (1), und
a3) einem Widerstandselement (4) aus einem Widerstandsmaterial, wobei das Widerstandselement (4) elektrisch zwischen das erste Anschlussteil (2) und das zweite Anschlussteil (3) geschaltet ist und von dem zu messenden Strom (I) durchflossen wird, und
b) einer baulich integrierten Messschaltung (17), insbesondere als anwendungsspezifische integrierte Schaltung, insbesondere mit einer 16-Bit-Messwerterfassung, wobei die Messschaltung (17) die über dem Widerstandselement (4) abfallende elektrische Spannung misst,
c) mehreren Paaren von Spannungsabgriffen zur Messung der über dem Widerstandselement (4) abfallenden elektrischen Spannung, wobei die Paare von Spannungsabgriffen mit der Messschaltung (17) verbunden sind, und
d) einem ersten Stromschienenanschluss (13) aus einem Leitermaterial zur elektrischen und mechanischen Verbindung mit einer ersten Stromschiene (15), wobei der erste Stromschienenanschluss (13) elektrisch mit dem ersten Anschlussteil (2) des Strommesswiderstands (1) verbunden ist, und
e) einem zweiten Stromschienenanschluss (14) aus einem Leitermaterial zur elektrischen und mechanischen Verbindung mit einer zweiten Stromschiene (16), wobei der zweite Stromschienenanschluss (14) elektrisch mit dem zweiten Anschlussteil (3) des Strommesswiderstands (1) verbunden ist,
**dadurch gekennzeichnet,**
f) dass der Strommesswiderstand (1) mehrere ebene Verbundmaterialplatten aufweist, die jeweils das Widerstandselement (4) und die Anschlussteile (2, 3) umfassen,
g) dass die Verbundmaterialplatten parallel zueinander angeordnet sind,
h) dass die benachbarten Verbundmaterialplatten an den Anschlussteilen elektrisch und mechanisch miteinander verbunden sind,
i) dass die benachbarten Verbundmaterialplatten im Bereich des Widerstandselements (4) durch einen Isolierspalt elektrisch voneinander getrennt sind, und
j) dass die Verbundmaterialplatten jeweils mehrere Schlitze (5) aufweisen, die längs zur Stromflussrichtung verlaufen und quer zur Stromflussrichtung nebeneinander angeordnet sind und in den Verbundmaterialplatten jeweils mehrere Widerstandselemente (4) voneinander trennen.

2. Messanordnung (12) nach Anspruch 1,
**dadurch gekennzeichnet,**
a) **dass** der erste Stromschienenanschluss (13) mehrere parallel übereinander liegende Anschlussplatten (24, 25, 26) aus einem Leitermaterial aufweist, und
b) **dass** der zweite Stromschienenanschluss (14) mehrere parallel übereinander liegende Anschlussplatten (21, 22, 23) aus einem Leitermaterial aufweist.

3. Messanordnung (12) nach einem der vorhergehenden Ansprüche, **dadurch gekennzeichnet,**
a) **dass** der erste Stromschienenanschluss (13) und/oder der zweite Stromschienenanschluss (14) zur Schraubmontage ausgelegt ist, und/oder
b) **dass** der erste Stromschienenanschluss (13) und/oder der zweite Stromschienenanschluss (14) mindestens teilweise vernickelt ist.

4. Messanordnung (12) nach einem der vorhergehenden Ansprüche, **dadurch gekennzeichnet,**
a) **dass** die Messanordnung (12) mehrere niederohmige Strommesswiderstände (1) aufweist, die elektrisch parallel geschaltet sind, so dass sich der zu messende Strom in mehrere Teilströme aufteilt, die durch die einzelnen Strommesswiderstände (1) fließen, und/oder
b) **dass** die Strommesswiderstände (1) in mehreren Ebenen übereinander angeordnet sind, und/oder
c) **dass** in jeder der Ebenen jeweils mehrere Strommesswiderstände (1) nebeneinander angeordnet sind.

5. Messanordnung (12) nach einem der vorhergehenden Ansprüche, **dadurch gekennzeichnet,**
a) **dass** die Messanordnung (12) eine baulich integrierte Datenschnittstelle (19) aufweist zum Senden und/oder zum Empfangen von Daten, und
b) **dass** die Datenschnittstelle (19) einen Optokoppler aufweist, und
c) **dass** an den Optokoppler (19) ein Lichtleiter (20) angeschlossen ist, und
d) **dass** die Datenschnittstelle (19) zusammen mit dem Lichtleiter (20) eine galvanische Trennung bildet.

6. Messanordnung (12) nach einem der vorhergehenden Ansprüche,
**dadurch gekennzeichnet,**
a) **dass** die Messschaltung (17) in einer elektrischen Abschirmung aus einem Leitermaterial eingekapselt sind, und/oder
b) **dass** die elektrische Abschirmung mindestens teilweise gebildet wird aus den Stromschienenanschlüssen (13, 14) und/oder aus Distanzstücken (27-32) aus einem Leitermaterial zwischen den Stromschienenanschlüssen (13, 14) und/oder aus seitlichen Verstärkungsplatten aus einem Leitermaterial.

7. Messanordnung (12) nach einem der vorhergehenden Ansprüche, **dadurch gekennzeichnet,**
a) **dass** die Paare von Spannungsabgriffen quer zur Stromflussrichtung nebeneinander angeordnet sind, und/oder
b) **dass** die Messschaltung (17) die an den Paaren der Spannungsabgriffe abfallenden Spannungen synchron mit einer hohen Abtastrate misst, vorzugsweise mit einer Abtastrate von mindestens 4 kHz, und/oder
c) **dass** die Messschaltung (17) aus den an den Paaren der Spannungsabgriffe gemessenen Spannungen einen Mittelwert berechnet, insbesondere einen gewichteten Mittelwert.

8. Messanordnung (12) nach einem der vorhergehenden Ansprüche, **dadurch gekennzeichnet,**
a) **dass** mindestens ein Temperatursensor (9) vorgesehen ist zur Temperaturmessung an dem Strommesswiderstand (1),
b) **dass** die Messschaltung (17) mit dem Temperatursensor verbunden ist,
c) **dass** der Strommesswiderstand (1) einen temperaturabhängigen Widerstandswert hat, und
d) **dass** die Messschaltung (17) die Temperaturabhängigkeit des Widerstandswerts entsprechend der von dem Temperatursensor (9) gemessenen Temperatur kompensiert.

9. Messanordnung (12) nach einem der vorhergehenden Ansprüche, **dadurch gekennzeichnet,**
a) **dass** das Widerstandselement (4) des Strommesswiderstands (1) eine bestimmte Thermokraft aufweist, die bei einem Temperaturunterschied zwischen dem Widerstandselement (4) einerseits und den Anschlussteilen andererseits eine bestimmte Thermospannung erzeugt, und
b) **dass** zur Kompensation der über dem Widerstandselement (4) abfallenden Thermospannung ein Ausgleichselement (10) vorgesehen ist,
c) **dass** das Ausgleichselement (10) thermisch mit den beiden Anschlussteilen (2, 3) verbunden ist und somit denselben Temperaturunterschieden ausgesetzt ist wie das Widerstandselement (4),
d) **dass** das Ausgleichselement (10) bei einem Temperaturunterschied zwischen dem Ausgleichselement (10) einerseits und den Anschlussteilen (2, 3) andererseits eine bestimmte Thermospannung erzeugt, und
e) **dass** das Ausgleichselement (10) und das Widerstandselement (4) in einem Spannungsmesskreis elektrisch in Reihe geschaltet und mit der Messschaltung (17) verbunden sind, so dass sich die Thermospannungen des Widerstandselements (4) einerseits und des Ausgleichselements (10, 11) andererseits mindestens teilweise kompensieren.

10. Messanordnung (12) nach Anspruch 9, **dadurch gekennzeichnet,**
a) **dass** zur rechnerischen Kompensation der über dem Widerstandselement (4) entstehenden Thermospannung ein Thermoelement (11) zur Messung der Temperaturdifferenz über dem Widerstandselement (4) vorgesehen ist, und
b) **dass** die Messschaltung (17) mit dem Thermoelement (11) verbunden ist.

11. Messanordnung (12) nach den Ansprüchen 8 und 9, **dadurch gekennzeichnet,**
a) **dass** Spannungsabgriffe vorgesehen sind zum Abgreifen der über dem Strommesswiderstand abfallenden elektrischen Spannung, und/oder
b) **dass** die Spannungsabgriffe in ein Flachbandkabel (6) integriert sind, und/oder
c) **dass** das Flachbandkabel (6) auf den Strommesswiderstand (1) aufgelötet ist, und/oder
d) **dass** das Flachbandkabel (6) mehrlagig ist, und/oder
e) **dass** das Flachbandkabel (6) einen Streifenleiter bildet, und/oder
f) **dass** der Temperatursensor auf dem Flachbandkabel (6) angebracht ist, und/oder
g) **dass** das zum Ausgleich der Thermospannung dienende Ausgleichselement auf dem Flachbandkabel (6) angebracht ist, und/oder
h) **dass** das zur Temperaturdifferenzmessung dienende Thermoelement (11) auf dem Flachbandkabel (6) angebracht ist.

12. Messanordnung (12) nach Anspruch 11, **dadurch gekennzeichnet,**
a) **dass** zwischen dem Flachbandkabel (6) und dem Strommesswiderstand (1) ein Plättchen (7) aus einem Leitermaterial angeordnet ist, insbesondere aus Kupfer, und/oder
b) **dass** das Plättchen (7) durch Löten, Sintern, Schweißen oder Leit-Kleben mit dem Strommesswiderstand (1) verbunden ist, und/oder
c) **dass** das Plättchen (7) Anschlussstifte (8) zur elektrischen Kontaktierung des Flachbandkabels (6) aufweist, und/oder
d) **dass** die Anschlussstifte (8) des Plättchens (7) mit elektrischen Anschlussstellen des Flachbandkabels (6) verbunden sind, insbesondere durch Verlöten, Verkleben oder Verschweißen.

13. Messanordnung (12) nach einem der vorhergehenden Ansprüche, **dadurch gekennzeichnet,**
a) **dass** die Messanordnung (12) zur Stromversorgung der Messschaltung (17) einen Hochspanungstransformator (18) aufweist,
oder
b) **dass** die Messanordnung (12) zur Stromversorgung der Messschaltung (17) eine photovoltaische Zelle (18) aufweist, die zur Stromerzeugung über einen Lichtleiter von einer Lichtquelle bestrahlt wird, insbesondere von einem Laser.

14. Messanordnung (12) nach einem der vorhergehenden AnSprüche, **dadurch gekennzeichnet,**
a) **dass** der Strommesswiderstand (1) einen Widerstandswert höchstens 1 mΩ, 500µΩ, 250µΩ, 100 µΩ, 50 µΩ, 25 µΩ, 10 µΩ, 5 µΩ, 2 µΩ oder höchstens 1 µΩ aufweist, und/oder
b) **dass** das Widerstandsmaterial des Strommesswiderstands (1) eines der folgenden Materialien ist:
b1) eine Kupfer-Mangan-Nickel-Legierung besteht, insbesondere aus Cu86Mn12Ni2,
b2) eine Kupfer-Mangan-Zinn-Legierung, insbesondere Cu90,7Mn7Sn2,3,
b3) eine Nickel-Chrom-Legierung, insbesondere eine Nickel-Chrom-Aluminium-Legierung, insbesondere Ni74,5Cr20Al3,5Si1Mn0,5Fe0,5, und/oder
c) **dass** das Leitermaterial Kupfer oder eine Kupferlegierung ist, und/oder
d) **dass** das Leitermaterial einen kleineren spezifischen elektrischen Widerstand aufweist als das Widerstandsmaterial, und/oder
e) **dass** die Messanordnung (12) mit einem kurzzeitigen Maximalstrom von mindestens 10 kA, 25 kA, 50 kA, 100kA, 200 kA, 500kA impulsbelastbar ist, insbesondere mit einer Impulsdauer von 100 ms, und/oder
f) **dass** die Messanordnung (12) mit einem Dauerstrom von mindestens 1kA, 2 kA, 5 kA, 10 kA, 20 kA oder 30 kA belastbar ist, und/oder
g) **dass** das Widerstandselement (4) in Stromflussrichtung eine Länge von höchstens 50 mm, 25 mm, 10 mm, 7 mm oder 5 mm aufweist, und/oder
h) **dass** die Messschaltung (17) und die Datenschnittstelle (19) innerhalb einer elektrischen Abschirmung angeordnet sind, und/oder
i) **dass** die Messanordnung (12) einen Linearitätsfehler von weniger als 0,1%, 0,05%, 0,01%, 0,005% aufweist, und/oder
j) **dass** die Messschaltung (17) offset-frei ist, und/oder
k) **dass** die Messschaltung (17) eine Abtastrate von mindestens 500 Hz, 1kHz, 2 kHz oder mindestens 4 kHz aufweist, und/oder
l) **dass** das Widerstandselement (4) des Strommesswiderstands (1) plattenförmig ist, und/oder
m) **dass** das erste Anschlussteil und/oder das zweite Anschlussteil des Strommesswiderstands (1) plattenförmig ist, und/oder
n) **dass** die Messanordnung (12) einen geringen thermischen Innenwiderstand aufweist von weniger als 1 K/W, 0,5 K/W, 0,1 K/W, 0,05 K/W oder 0,02 K/W, und/oder
o) **dass** die Messschaltung (17) zur Dauerstromerfassung einen ersten Messkanal mit einer ersten Abtastrate und zur Überstromerfassung eine separaten zweiten Messkanal mit einer höheren zweiten Abtastrate aufweist, und/oder
p) **dass** das Widerstandselement (4) mit dem ersten Anschlussteil und mit dem zweiten Anschlussteil durch eine Schweißverbindung verbunden ist, insbesondere durch eine Elektronenstrahlverschweißung, und/oder
q) **dass** der Strommesswiderstand (1) mehrere Schlitze aufweist, die längs zur Stromflussrichtung verlaufen und quer zur Stromflussrichtung nebeneinander angeordnet sind und mehrere Widerstandselemente voneinander trennen, so dass sich der zur messende elektrische Strom aufteilt und durch die einzelnen Widerstandselemente (4) fließt.

## Claims

1. Measuring arrangement (12) for measuring an electric current (I) in the high-current range, in particular in the current range of more than 1kA, having
a) a low-resistance current sense resistor (1) for current measurement in accordance with the four-wire technology, with
a1) a first connecting part (2) made of a conductor material for introducing the electric current (I) to be measured into the current sense resistor (1),
a2) a second connecting part (3) made of a conductor material for conducting the electric current (I) to be measured out of the current-measuring resistor (1), and
a3) a resistor element (4) made of a resistance material, the resistor element (4) being electrically connected between the first terminal part (2) and the second terminal part (3) and the current (I) to be measured flowing through it, and
b) a structurally integrated measuring circuit (17), in particular as an application-specific integrated circuit, in particular with a 16-bit measured value acquisition, the measuring circuit (17) measuring the electrical voltage which drops across the resistor element (4),
c) a plurality of pairs of voltage taps for measuring the electric voltage falling across the resistor element (4), the pairs of voltage taps being connected to the measuring circuit (17), and
d) a first busbar connection (13) made of a conductive material for electrical and mechanical connection to a first busbar (15), the first busbar connection (13) being electrically connected to the first connecting part (2) of the current sense resistor (1), and
e) a second busbar connection (14) made of a conductor material for electrical and mechanical connection to a second busbar (16), the second busbar connection (14) being electrically connected to the second connecting part (3) of the current sense resistor (1),
**characterized in that**
f) the current sense resistor (1) has a plurality of planar composite material plates which each comprise the resistor element (4) and the connecting parts (2, 3),
g) that the composite material plates are arranged parallel to each other,
h) that the adjacent composite material plates are electrically and mechanically connected to each other at the connecting parts,
i) that the adjacent composite material plates in the region of the resistor element (4) are electrically separated from one another by an insulating gap, and
j) that the composite material plates each have a plurality of slots (5) which run longitudinally to the direction of current flow and are arranged next to one another transversely to the direction of current flow and, in the composite material plates, each separate a plurality of resistor elements (4) from one another.

2. Measuring arrangement (12) according to claim 1,
**characterized in that**
a) the first busbar connection (13) has a plurality of parallel connecting plates (24, 25, 26) which are arranged one above the other and consist of a conductor material, and
b) **in that** the second busbar connection (14) has a plurality of parallel connecting plates (21, 22, 23) which are arranged one above the other and are made of a conductor material.

3. Measuring arrangement (12) in accordance with one of the preceding claims, **characterized in that**
a) the first busbar connection (13) and/or the second busbar connection (14) is designed for screw mounting, and/or
b) **in that** the first busbar connection (13) and/or the second busbar connection (14) is at least partially nickel-plated.

4. Measuring arrangement (12) in accordance with one of the preceding claims, **characterized in that**
a) the measuring arrangement (12) has a plurality of low-resistance current sense resistors (1) which are connected electrically in parallel, so that the current to be measured is divided into a plurality of partial currents which flow through the individual current sense resistors (1), and/or
b) **in that** the current sense resistors (1) are arranged one above the other in a plurality of planes, and/or
c) **in that** in each of the planes in each case a plurality of current sense resitors (1) are arranged next to one another.

5. Measuring arrangement (12) in accordance with one of the preceding claims, **characterized in that**
a) the measuring arrangement (12) has a structurally integrated data interface (19) for transmitting and/or receiving data, and
b) **in that** the data interface (19) has an optocoupler, and
c) **in that** an optical fibre (20) is connected to the optocoupler (19), and
d) **in that** the data interface (19) together with the optical fibre (20) forms an electrical isolation.

6. Measuring arrangement (12) in accordance with one of the preceding claims, **characterized in that**
a) the measuring circuit (17) is encapsulated in an electrical shielding made of a conductor material, and/or
b) **in that** the electrical shielding is formed at least partially from the busbar connections (13, 14) and/or from spacers (27-32) made of a conductor material between the busbar connections (13, 14) and/or from lateral reinforcing plates made of a conductor material.

7. Measuring arrangement (12) in accordance with one of the preceding claims, **characterized in that**
a) the pairs of voltage taps are arranged next to one another transversely to the direction of current flow, and/or
b) **in that** the measuring circuit (17) measures the voltages falling at the pairs of voltage taps synchronously at a high sampling rate, preferably at a sampling rate of at least 4 kHz, and/or
c) the measuring circuit (17) calculates an average value, in particular a weighted average value, from the voltages measured at the pairs of voltage taps.

8. Measuring arrangement (12) according to one of the preceding claims, **characterised in that**
a) at least one temperature sensor (9) is provided for temperature measurement at the current sense resistor (1),
b) **in that** the measuring circuit (17) is connected to the temperature sensor,
c) **in that** the current sense resistor (1) has a temperature-dependent resistance value, and
d) **in that** the measuring circuit (17) compensates the temperature dependence of the resistance value in accordance with the temperature measured by the temperature sensor (9).

9. Measuring arrangement (12) in accordance with one of the preceding claims, **characterized in that**
a) the resistor element (4) of the current sense resistor (1) has a specific thermoelectric force which generates a specific thermoelectric voltage in the event of a temperature difference between the resistor element (4) on the one hand and the connecting parts on the other hand, and
b) **in that** a compensating element (10) is provided for compensating the thermoelectric voltage which drops across the resistor element (4),
c) **in that** the compensating element (10) is thermally connected to the two connecting parts (2, 3) and is thus exposed to the same temperature differences as the resistor element (4),
d) **in that** the compensating element (10) generates a specific thermoelectric voltage in the event of a temperature difference between the compensating element (10) on the one hand and the connecting parts (2, 3) on the other hand, and
e) **in that** the compensating element (10) and the resistor element (4) are electrically connected in series in a measuring circuit for voltage measuring and are connected to the measuring circuit (17) so that the thermoelectric voltages of the resistor element (4) on the one hand and of the compensating element (10, 11) on the other hand at least partially compensate each other.

10. Measuring arrangement (12) according to claim 9,
**characterised in that**
a) for measuring the temperature difference across the resistor element (4), a thermocouple (11) is provided for the purpose of computationally compensating the thermoelectric voltage which arises over the resistor element (4), and
b) **in that** the measuring circuit (17) is connected to the thermocouple (11).

11. Measuring arrangement (12) in accordance with claims 8 and 9, **characterized in that**
a) voltage taps are provided for sensing the electrical voltage falling across the current sense resistor, and/or
b) **in that** the voltage taps are integrated into a flat ribbon cable (6), and/or
c) **in that** the flat ribbon cable (6) is soldered onto the current sense resistor (1), and/or
d) that the ribbon cable (6) is multi-layered, and/or
e) that the flat ribbon cable (6) forms a strip conductor, and/or
f) the temperature sensor is mounted on the ribbon cable (6), and/or
g) **in that** the compensating element which serves to compensate the thermoelectric voltage is mounted on the flat ribbon cable (6), and/or
h) **in that** the thermal element (11) used for temperature difference measurement is mounted on the flat ribbon cable (6).

12. Measuring arrangement (12) according to Claim 11, **characterised in that**
a) a plate (7) made of a conductor material, in particular made of copper, is arranged between the flat ribbon cable (6) and the current sense resistor (1), and/or
b) **in that** the plate (7) is connected to the current sense resistor (1) by soldering, sintering, welding or conductive adhesive bonding, and/or
c) **in that** the plate (7) has connecting pins (8) for making electrical contact with the flat ribbon cable (6), and/or
d) **in that** the connecting pins (8) of the plate (7) are connected to electrical connection points of the flat ribbon cable (6), in particular by soldering, gluing or welding.

13. Measuring arrangement (12) in accordance with one of the preceding claims, **characterized in that**
a) the measuring arrangement (12) has a high-voltage transformer (18) for supplying power to the measuring circuit (17), or
b) **in that** the measuring arrangement (12) for supplying power to the measuring circuit (17) has a photovoltaic cell (18) which is irradiated by a light source, in particular by a laser, for generating current via a light guide.

14. Measuring arrangement (12) in accordance with one of the preceding claims, **characterized in that**
a) the current sense resistor (1) has a resistance value of not more than 1 mΩ, 500 µΩ, 250 µΩ, 100 µΩ, 50 µΩ, 25 µΩ, 10 µΩ, 5 µΩ, 2 µΩ or not more than 1 µΩ, and/or
b) that the resistance material of the current sense resistor (1) is one of the following materials:
b1) a copper-manganese-nickel alloy, in particular Cu86Mn12Ni2,
b2) a copper-manganese-tin alloy, in particular Cu90,7Mn7Sn2,3,
b3) a nickel-chromium alloy, in particular a nickel-chromium-aluminium alloy, in particular Ni74.5Cr20Al3.5Si1Mn0.5Fe0.5, and/or
c) that the conductor material is copper or a copper alloy, and/or
d) that the conductor material has a lower resistivity than the resistor material, and/or
e) **in that** the measuring arrangement (12) can be pulse-loaded with a short-term maximum current of at least 10 kA, 25 kA, 50 kA, 100 kA, 200 kA, 500 kA, in particular with a pulse duration of 100 ms, and/or
f) that the measuring arrangement (12) can be loaded with a continuous current of at least 1 kA, 2 kA, 5 kA, 10 kA, 20 kA or 30 kA, and/or
g) that the resistor element (4) has a length in the direction of current flow not exceeding 50 mm, 25 mm, 10 mm, 7 mm or 5 mm; and/or
h) that the measuring circuit (17) and the data interface (19) are arranged within an electrical shielding, and/or
i) the measuring arrangement (12) has a linearity error of less than 0.1%, 0.05%, 0.01%, 0.005%, and/or
j) that the measuring circuit (17) is offset-free, and/or
k) **in that** the measuring circuit (17) has a sampling rate of at least 500 Hz, 1 kHz, 2 kHz or at least 4 kHz, and/or
l) **in that** the resistor element (4) of the current sense resistor (1) is plate-shaped, and/or
m) **in that** the first connecting part and/or the second connecting part of the current sense resistor (1) is plate-shaped, and/or
n) **in that** the measuring arrangement (12) has a low internal thermal resistance of less than 1 K/W, 0.5 K/W, 0.1 K/W, 0.05 K/W or 0.02 K/W, and/or
o) **in that** the measuring circuit (17) has a first measuring channel with a first sampling rate for continuous current detection and a separate second measuring channel with a higher second sampling rate for overcurrent detection, and/or
p) **in that** the resistor element (4) is connected to the first connecting part and to the second connecting part by a welded joint, in particular by electron beam welding, and/or
q) **in that** the current sense resistor (1) has a plurality of slots which run longitudinally to the current flow direction and are arranged next to one another transversely to the current flow direction and separate a plurality of resistor elements from one another so that the electric current to be measured is divided and flows through the individual resistor elements (4).

## Revendications

1. Ensemble de mesure (12) servant à mesurer un courant électrique (I) dans la plage de courants forts, en particulier dans la plage de courants supérieurs à 1 kA, avec
a) une résistance de mesure de courant (1) à faible valeur ohmique servant à mesurer le courant selon la technique 4 fils, avec
a1) une première partie de raccordement (2) composée d'un matériau conducteur servant à introduire le courant (I) électrique à mesurer dans la résistance de mesure de courant (1),
a2) une deuxième partie de raccordement (3) composée d'un matériau conducteur servant à évacuer le courant (I) électrique à mesurer hors de la résistance de mesure de courant (1),
et
a3) un élément de résistance (4) composé d'un matériau de résistance, dans lequel l'élément de résistance (4) est branché de manière électrique entre la première partie de raccordement (2) et la deuxième partie de raccordement (3) et est traversé par le courant (I) à mesurer, et
b) un circuit de mesure (17) intégré sur le plan de la construction, en particulier en tant que circuit intégré spécifique à l'utilisation, en particulier avec une détection de valeur de mesure de 16 bits, dans lequel le circuit de mesure (17) mesure la baisse de la tension électrique sur l'élément de résistance (4),
c) plusieurs paires de points de prélèvement de tension servant à mesurer la baisse de tension électrique sur l'élément de résistance (4), dans lequel les paires de points de prélèvement de tension sont reliées au circuit de mesure (17), et
d) un premier raccord de barre omnibus (13) composé d'un matériau conducteur destiné à être relié de manière électrique et de manière mécanique à une première barre omnibus (15), dans lequel le premier raccord de barre omnibus (13) est relié de manière électrique à la première partie de raccordement (2) de la résistance de mesure de courant (1), et
e) un deuxième raccord de barre omnibus (14) composé d'un matériau conducteur, destiné à être relié de manière électrique et de manière mécanique à une deuxième barre omnibus (16), dans lequel le deuxième raccord de barre omnibus (14) est relié de manière électrique à la deuxième partie de raccordement (3) de la résistance de mesure de courant (1),
**caractérisé en ce**
f) que la résistance de mesure de courant (1) présente plusieurs plaques de matériau composite planes, qui comprennent respectivement l'élément de résistance (4) et les parties de raccordement (2, 3),
g) que les plaques de matériau composite sont disposées de manière parallèle les unes par rapport aux autres,
h) que les plaques de matériau composite adjacentes sont reliées les unes aux autres de manière électrique et de manière mécanique au niveau des parties de raccordement,
i) que les plaques de matériau composite adjacentes sont séparées de manière électrique les unes des autres dans la zone de l'élément de résistance (4) par une fente d'isolation, et
j) que les plaques de matériau composite présentent respectivement plusieurs entailles (5), qui s'étendent le long de la direction du flux de courant et sont disposées les unes à côté des autres de manière transversale par rapport à la direction de flux de courant et séparent respectivement plusieurs éléments de résistance (4) les uns des autres dans les plaques de matériau composite.

2. Ensemble de mesure (12) selon la revendication 1,
**caractérisé en ce**
a) **que** le premier raccord de barre omnibus (13) présente des plaques de raccordement (24, 25, 26) situées de manière parallèle les unes par-dessus les autres, composées d'un matériau conducteur, et
b) **que** le deuxième raccord de barre omnibus (14) présente plusieurs plaques de raccordement (21, 22, 23) situées de manière parallèle les unes par-dessus les autres, composées d'un matériau conducteur.

3. Ensemble de mesure (12) selon l'une quelconque des revendications précédentes, **caractérisé en ce**
a) **que** le premier raccord de barre omnibus (13) et/ou le deuxième raccord de barre omnibus (14) sont configurées aux fins du montage par vissage, et/ou
b) **que** le premier raccord de barre omnibus (13) et/ou le deuxième raccord de barre omnibus (14) sont au moins en partie nickelés.

4. Ensemble de mesure (12) selon l'une quelconque des revendications précédentes, **caractérisé en ce**
a) **que** l'ensemble de mesure (12) présente plusieurs résistances de mesure de courant (1) à faible valeur ohmique, qui sont branchées de manière électrique en parallèle de sorte que le courant à mesurer se répartit en plusieurs courants partiels, qui circulent à travers les diverses résistances de mesure de courant (1), et/ou
b) **que** les résistances de mesure de courant (1) sont disposées les unes par-dessus les autres dans plusieurs niveaux, et/ou
c) **que** dans chacun des niveaux, respectivement plusieurs résistances de mesure de courant (1) sont disposées les unes à côté des autres.

5. Ensemble de mesure (12) selon l'une quelconque des revendications précédentes, **caractérisé en ce**
a) **que** l'ensemble de mesure (12) présente une interface de données (19) intégrée sur le plan de la construction, servant à envoyer et/ou à recevoir des données, et
b) **que** l'interface de données (19) présente un optocoupleur, et
c) **qu'**un guide de lumière (20) est disposé au niveau de l'optocoupleur (19) et
d) **que** l'interface de données (19) forme conjointement avec le guide de lumière (20) une séparation galvanique.

6. Ensemble de mesure (12) selon l'une quelconque des revendications précédentes,
**caractérisé en ce**
a) **que** le circuit de mesure (17) est encapsulé dans un blindage électrique composé d'un matériau conducteur, et/ou
b) **que** le blindage électrique est formé au moins en partie à partir des raccords de barre omnibus (13, 14) et/ou à partir de pièces d'écartement (27 - 32) composées d'un matériau conducteur entre les raccords de barre omnibus (13, 14) et/ou à partir de plaques de renforcement latérales composées d'un matériau conducteur.

7. Ensemble de mesure (12) selon l'une quelconque des revendications précédentes, **caractérisé en ce**
a) **que** les paires de points de prélèvement de tension sont disposées les unes à côté des autres de manière transversale par rapport à la direction de flux de courant, et/ou
b) **que** le circuit de mesure (17) mesure de manière synchrone la baisse de tensions au niveau des paires des points de prélèvement de tension avec une vitesse de balayage élevée, de préférence avec une vitesse de balayage d'au moins 4 kHz, et/ou
c) **que** le circuit de mesure (17) calcule à partir des tensions mesurées au niveau des paires des points de prélèvement de tension une valeur moyenne, en particulier une valeur moyenne pondérée.

8. Ensemble de mesure (12) selon l'une quelconque des revendications précédentes, **caractérisé en ce**
a) **qu'**est prévu au moins un capteur de température (9) servant à mesurer la température au niveau de la résistance de mesure de courant (1),
b) **que** le circuit de mesure (17) est relié au capteur de température,
c) **que** la résistance de mesure de courant (1) a une valeur de résistance dépendant de la température, et
d) **que** le circuit de mesure (17) compense la dépendance à la température de la valeur de résistance conformément à la température mesurée par le capteur de température (9).

9. Ensemble de mesure (12) selon l'une quelconque des revendications précédentes, **caractérisé en ce**
a) **que** l'élément de résistance (4) de la résistance de mesure de courant (1) présente une puissance thermoélectrique définie, qui génère, dans le cas d'une différence de température entre l'élément de résistance (4) d'une part et les parties de raccordement d'autre part, une tension thermoélectrique définie, et
b) **que** pour la compensation de la baisse de la tension thermoélectrique sur l'élément de résistance (4), un élément de compensation (10) est prévu,
c) **que** l'élément de compensation (10) est relié de manière thermique aux deux parties de raccordement (2, 3) et est ainsi exposé aux mêmes différences de température que l'élément de résistance (4),
d) **que** l'élément de compensation (10) génère dans le cas d'une différence de température entre l'élément de compensation (10) d'une part et les parties de raccordement (2, 3) d'autre part, une tension thermoélectrique définie, et
e) **que** l'élément de compensation (10) et l'élément de résistance (4) sont branchés de manière électrique en série dans un circuit de mesure de tension et sont reliés au circuit de mesure (17) de sorte que les tensions thermoélectriques de l'élément de résistance (4) d'une part et de l'élément de compensation (10, 11) d'autre part se compensent au moins en partie.

10. Ensemble de mesure (12) selon la revendication 9,
**caractérisé en ce**
a) **que** pour compenser de manière arithmétique la tension thermoélectrique se formant sur l'élément de résistance (4), un élément thermoélectrique (11) est prévu pour mesurer la différence de température sur l'élément de résistance (4), et
b) **que** le circuit de mesure (17) est relié à l'élément thermoélectrique (11).

11. Ensemble de mesure (12) selon les revendications 8 et 9, **caractérisé en ce**
a) **que** sont prévus des points de prélèvement de tension servant à prélever la tension électrique en baisse sur la résistance de mesure de courant, et/ou
b) **que** les points de prélèvement de tension sont intégrés dans un câble à bande plate (6), et/ou
c) **que** le câble à bande plate (6) est brasé sur la résistance de mesure de courant (1), et/ou
d) **que** le câble à bande plate (6) est multicouche, et/ou
e) **que** le câble à bande plate (6) forme un conducteur en bande, et/ou
f) **que** le capteur de température est installé sur le câble à bande plate (6), et/ou
g) **que** l'élément de compensation servant à la compensation de la tension thermoélectrique est installé sur le câble à bande plate (6), et/ou
h) **que** l'élément thermoélectrique (11) servant à la mesure de différence de température est installé sur le câble à bande plate (6).

12. Ensemble de mesure (12) selon la revendication 11, **caractérisé en ce**
a) **qu'**est disposée entre le câble à bande plate (6) et la résistance de mesure de courant (1) une petite plaque (7) composée d'un matériau conducteur, en particulier composée de cuivre, et/ou
b) **que** la petite plaque (7) est reliée par brasage, frittage, soudage ou collage de manière conductrice à la résistance de mesure de courant (1), et/ou
c) **que** la petite plaque (7) présente des tiges de raccordement (8) servant à établir un contact électrique avec le câble à bande plate (6), et/ou
d) **que** les tiges de raccordement (8) de la petite plaque (7) sont reliées à des emplacements de raccordement électriques du câble à bande plate (6), en particulier par brasage, collage ou soudage.

13. Ensemble de mesure (12) selon l'une quelconque des revendications précédentes, **caractérisé en ce**
a) **que** l'ensemble de mesure (12) servant à l'alimentation en courant du circuit de mesure (17) présente un transformateur à haute tension (18),
ou
b) **que** l'ensemble de mesure (12) servant à l'alimentation en courant du circuit de mesure (17) présente une cellule photovoltaïque (18), qui est exposée au rayonnement d'une source de lumière, en particulier d'un laser, aux fins de la génération de courant par l'intermédiaire d'un guide de lumière.

14. Ensemble de mesure (12) selon l'une quelconque des revendications précédentes, **caractérisé en ce**
a) **que** la résistance de mesure de courant (1) présente une valeur de résistance au maximum de 1 mΩ, 500 µΩ, 250 µΩ, 100 µΩ, 50 µΩ, 25 µΩ, 10 µΩ, 5 µΩ, 2 µΩ ou au maximum de 1 µΩ, et/ou
b) **que** le matériau de résistance de la résistance de mesure de courant (1) est un des matériaux suivants :
b1) un alliage de cuivre-manganèse-nickel, en particulier Cu86Mn12Ni2,
b2) un alliage de cuivre-manganèse-étain, en particulier Cu90, 7Mn7Sn2,3,
b3) un alliage de nickel-chrome, en particulier un alliage de nickel-chrome-aluminium, en particulier Ni74,5Cr20Al3,5Si1Mn0,5Fe0,5, et/ou
c) **que** le matériau conducteur est du cuivre ou un alliage de cuivre, et/ou
d) **que** le matériau conducteur présente une résistance électrique spécifique inférieure à celle du matériau de résistance, et/ou
e) **que** l'ensemble de mesure (12) peut être soumis à une contrainte d'impulsion avec un bref courant maximal d'au moins 10 kA, 25 kA, 50 kA, 100 kA, 200 kA, 500 kA, en particulier avec une durée d'impulsion de 100 ms, et/ou
f) **que** l'ensemble de mesure (12) peut être soumis à une contrainte d'un courant durable d'au moins 1 kA, 2 kA, 5 kA, 10 kA, 20 kA ou 30 kA, et/ou
g) **que** l'élément de résistance (4) présente dans la direction de flux de courant une longueur au maximum de 50 mm, 25 mm, 10 mm, 7 mm ou de 5 mm, et/ou
h) **que** le circuit de mesure (17) et l'interface de données (19) sont disposés à l'intérieur d'un blindage électrique, et/ou
i) **que** l'ensemble de mesure (12) présente une erreur de linéarité inférieure à 0,1 %, 0,05 %, 0,01 %, 0,005 %, et/ou
j) **que** le circuit de mesure (17) est sans décalage, et/ou
k) **que** le circuit de mesure (17) présente une vitesse de balayage d'au moins 500 Hz, 1 kHz, 2 kHz ou d'au moins 4 kHz, et/ou
l) **que** l'élément de résistance (4) de la résistance de mesure de courant (1) est en forme de plaque, et/ou
m) **que** la première partie de raccordement et/ou la deuxième partie de raccordement de la résistance de mesure de courant (1) sont en forme de plaque, et/ou
n) **que** l'ensemble de mesure (12) présente une résistance intérieure thermique moindre inférieure à 1 K/W, 0,5 K/W, 0,1 K/W, 0,05 K/W ou 0,02 K/W, et/ou
o) **que** le circuit de mesure (17) présente pour la détection de courant durable un premier canal de mesure avec une première vitesse de balayage et pour la détection d'une surintensité un deuxième canal de mesure séparé avec une deuxième vitesse de balayage plus élevée, et/ou
p) **que** l'élément de résistance (4) est relié par une liaison par soudage à la première partie de raccordement et à la deuxième partie de raccordement, en particulier par un soudage par faisceau d'électrons, et/ou
q) **que** la résistance de mesure de courant (1) présente plusieurs entailles, qui s'étendent le long de la direction de flux de courant et sont disposées les unes à côté des autres de manière transversale par rapport à la direction de flux de courant et séparent les uns des autres plusieurs éléments de résistance de sorte que le courant électrique à mesurer se répartit et circule à travers les divers éléments de résistance (4).
